# EUROPÄISCHE PATENTANMELDUNG

(11) **EP 0 583 647 A2**
(43) Veröffentlichungstag der Anmeldung: **23.02.1994**
(21) Anmeldenummer: 93111807.9
(22) Anmeldetag: 23.07.1993
(51) Int. Cl.: H03M 13/00, G08G 1/054, G01P 21/02, G03B 17/24

(54) **Verfahren und Vorrichtung zur Sicherung von in ein Bild eingeblendeten Daten**

(30) Priorität: 14.08.1992 CH 2547/92
(71) Anmelder: MULTANOVA AG, CH-8610 Uster (CH)
(72) Erfinder: Mira, Silvio, CH-8615 Wermatswil (CH)
(74) Vertreter: Ellenberger, Maurice

(57) **Zusammenfassung**

Den in Form alfanumerischer Zeichen eingeblendeten Daten (D, h, v) wird Redundanz beigegeben, indem die Daten mit einem definierten Algorithmus kombiniert werden und daraus eine Prüfinformation in Form eines alfanumerisch darstellbaren Prüfzeichen (P) gewonnen wird. Dieses Prüfzeichen wird ebenfalls in das Bild (DF) eingeblendet. Bei Verarbeitung der eingeblendeten Daten (D, h, v) mit dem gleichen Algorithmus wird ebenfalls ein Prüfzeichen erhalten, dessen Uebereinstimmung mit dem eingeblendeten Prüfzeichen (P) die Richtigkeit der eingeblendeten Daten beweist.

Anwendung zur Datensicherung in Anlagen zur automatischen Geschwindigkeitsüberwachung, insbesondere in fotografierenden Radar-Geschwindigkeits-Messgeräten.

## Beschreibung

Die vorliegende Erfindung betrifft ein Verfahren und eine Vorrichtung zur Sicherung von in ein Bild in Form alfanumerischer Zeichen eingeblendeter Daten.

Die Sicherung von in ein Bild eingeblendeten Daten ist immer dann erforderlich, wenn das Bild mit den Daten zu Beweiszwecken verwendet wird, wie dies beispielsweise bei der automatischen Verkehrsüberwachung erfolgt, wo Zuwiderhandlungen gegen Verkehrsvorschriften beweiskräftig festgehalten werden. Dies kann beispielsweise dadurch geschehen, dass das fehlbare Fahrzeug fotografiert und die entsprechenden Daten, wie Geschwindigkeit, Datum und Uhrzeit, in Form alfanumerischer Zeichen in das Bild auf den Film eingeblendet werden. Die Umwandlung der elektrischen Datensignale in die optisch auf den Film zu übertragenden Zeichen geschieht dabei mittels bekannter Anzeigeelemente, wie zum Beispiel Leuchtdioden.

Zum Beweis dafür, dass die Einblendung richtig ist und die auf dem Bild sichtbaren Zeichen tatsächlich die zur Einblendung vorgesehenen Daten wiedergeben, ist es unter anderem bekannt, die elektrischen Eigenschaften der Anzeigeelemente zu überwachen. Dies erfolgt vorzugsweise durch Detektion oder Messung des Stroms durch die Leuchtdiodensegmente während der Einblendung. Weil aber nicht gewährleistet ist, dass sich eine die erwarteten elektrischen Eigenschaften aufweisende Leuchtdiode auch optisch richtig verhält, indem sie beispielsweise bei Stromdurchfluss auch tatsächlich leuchtet, ist diese Methode offensichtlich nicht ausreichend beweiskräftig.

Eine andere bekannte Methode besteht darin, am Anfang und gegebenenfalls auch am Ende jedes Films Testaufnahmen mit vorgegebenen Einblendedaten oder Einblendemustern vorzusehen und diese nachträglich zu überprüfen. Auch diese Methode ist kein zweifelsfrei sicherer Beweis, da sie nicht garantiert, dass die Einblendung auch bei jedem beliebigen Bild vor oder nach der Testaufnahme richtig funktioniert hat.

Durch die Erfindung sollen nun ein Verfahren und eine Vorrichtung zur Durchführung dieses Verfahrens angegeben werden, welche es ermöglichen, das richtige Funktionieren der Einblendung für jedes beliebige Bild zu überprüfen, ohne dass Testbilder oder Testeinblendungen zu Hilfe genommen oder an den Anzeigeelementen Messungen durchgeführt werden müssen.

Diese Aufgabe wird beim erfindungsgemässem Verfahren dadurch gelöst, dass den genannten Daten Redundanz in Form von zusätzlichen, durch Kombination zumindest einzelner Zeichen der Daten mit einem definierten Algorithmus gebildete Prüfinformation beigegeben und in das Bild eingeblendet wird.

Die Vorrichtung zur Durchführung des erfindungsgemässen Verfahrens ist gekennzeichnet durch eine Tabelle, in welcher jedem möglichen Zeichen ein Zahlenwert zugeordnet ist, durch Mittel zur Verarbeitung der den zumindest einzelnen Zeichen zugeordneten Zahlenwerte zu einer für die jeweilige Einblendung repräsentativen Prüfinformation, und durch Mittel zur alfanumerischen Anzeige und Einblendung dieser Prüfinformation in Form eines Prüfzeichens.

Im folgenden wird die Erfindung anhand eines in den Zeichnungen dargestellten Ausführungsbeispiels näher erläutert; es zeigt:
- Fig. 1: eine schematische Wiedergabe einer von einem Geschwindigkeits-Messgerät gemachten Fotografie; und
- Fig. 2: einen vergrösserten Teilausschnitt aus Fig. 1.

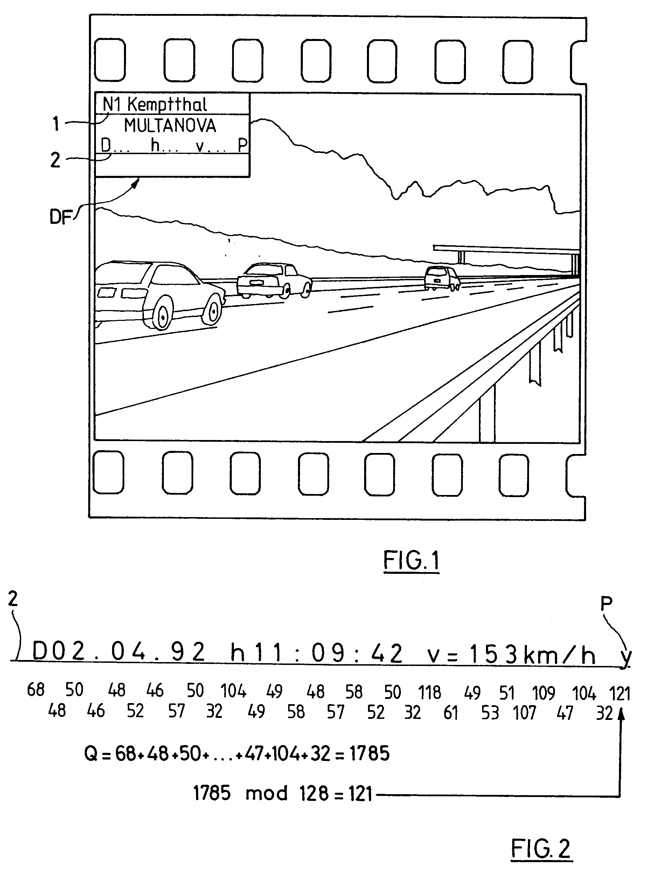

Die in Fig. 1 dargestellte Fotografie ist von der bekannten Art, wie sie beispielsweise mit dem fotografierenden Radar-Geschwindigkeits-Messgerät MULTANOVA 6F der Multanova AG (MULTANOVA - eingetragenes Warenzeichen der Zellweger Uster AG) hergestellt wird (siehe dazu die EP-B-0 188 694 und den dort zitierten Stand der Technik). Ein derartiges Messgerät wird neben oder über dem zu überwachenden Strassenabschnitt in einer festen Kabine, in einem Fahrzeug oder auf einem Stativ aufgestellt, und ermittelt nach dem bekannten Dopplerprinzip die Geschwindigkeit der die Messstelle passierenden Fahrzeuge, und zwar sowohl der abfliessenden als auch der entgegenkommenden. Wird ein die jeweilige Höchstgeschwindigkeit überschreitendes Fahrzeug gemessen, dann wird dieses fotografiert und es werden gleichzeitig die für die spätere Ahndung der Uebertretung erforderlichen Daten in ein vorzugsweise in der linken oberen Ecke der Fotografie vorgesehenes Datenfeld DF eingeblendet.

Das Datenfeld DF enthält darstellungsgemäss eine Zeile 1 für einen mitfotografierten, beliebig beschriftbaren Bezeichnungsstreifen, der vorzugsweise die nähere Bezeichnung der Messstelle enthält, und eine Datenzeile 2 für die erforderlichen Angaben von Datum D, Zeit h und Geschwindigkeit v. Die Einblendung P wird später anhand von Fig. 2 erläutert. Die Fotografie gemäss Fig. 1 zeigt also das fehlbare Fahrzeug, im Fall von Frontfotografie, also bei Kontrolle des entgegenkommenden Verkehrs, auch dessen Lenker(in), sowie Ort, Datum, Uhrzeit und gemessene Geschwindigkeit, also Grösse der Uebertretung. Der Bezeichnungsstreifen in Zeile 1 braucht nicht unbedingt vorhanden zu sein und die Datenzeile 2 kann selbstverständlich auch noch weitere Daten enthalten.

Die Einblendung des Datenfeldes DF in die Fotografie erfolgt durch eine in der Kamera enthaltene Einrichtung zur Uebertragung von alfanumerischen Informationen auf den Film. Diese Einrichtung enthält insbesondere Leuchtdioden zur Darstellung der alfanumerischen Zeichen und ein Abbildungssystem zur Abbildung dieser Zeichen auf die Filmebene, wobei die Leuchtdioden unter anderem von dem die Messergebnisse auswertenden Mikrorechner des Messgeräts angesteuert sind.

Fig. 2 zeigt eine vergrösserte Darstellung der Datenzeile 2 des Datenfeldes DF (Fig. 1). Man erkennt in der Reihenfolge von links nach rechts Datum D, Uhrzeit h und gemessene Geschwindigkeit v, das sind alfanumerische Datenzeichen, die für die gemessenen Daten stehen. Am Ende der Zeile ist nach der Geschwindigkeit v ein weiteres alfanumerisches Zeichen eingeblendet. Dieses ist ein Prüfzeichen P zur Ueberprüfung des richtigen Funktionierens der Einblendung.

Die Bildung des Prüfzeichens P erfolgt im Mikrorechner des Messgeräts durch Kombination der Datenzeichen der Datenzeile 2 nach einem festgelegten Algorithmus. Der Mikrorechner steuert dann die Leuchtdioden zur Anzeige des jeweiligen Prüfzeichens P an und dieses wird analog wie die Datenzeichen in das Datenfeld DF eingeblendet. Zur Ueberprüfung der Einblendung wird auf die in der Datenzeile 2 sichtbaren Datenzeichen der gleiche Algorithmus angewendet, und das dadurch gewonnene Prüfzeichen wird mit dem in der Datenzeile abgebildeten verglichen. Wenn die beiden Prüfzeichen nicht übereinstimmen, liegt ein Einblendefehler vor. Es kann unter Umständen ausreichend sein, nur die kritischen Daten, insbesondere die gemessene Geschwindigkeit v, auf diese Weise zu sichern, vorzugsweise wird aber das Prüfzeichen P anhand aller Datenzeichen für Datum D, Uhrzeit h und Geschwindigkeit v gebildet, so dass auch alle Datenzeichen der Datenzeile 2 gesichert sind.

Bei der bevorzugten konkreten Ausführung dieser Kombination der Datenzeichen wird eine Tabelle vorgesehen, in der jedem alfanumerischen Zeichen ein entsprechender Zahlenwert eindeutig zugeordnet ist. Dabei bedeutet alfanumerisches Zeichen nicht nur Buchstaben und Ziffern, sondern auch Interpunktionen, Leerfelder und mathematische oder sonstige Symbole. Eine geeignete Tabelle ist beispielsweise die aus der Datenverarbeitung bekannte ASCII-Tabelle. In Fig. 2 ist unterhalb der Datenzeile 2 für jedes Datenzeichen von Zeile 2 der entsprechende ASCII-Wert eingetragen.

Diese Werte werden nun zu einer Quersumme Q addiert und aus dieser Quersumme wird durch eine Art von Restklassenzerlegung mit einem geeigneten Modul eine Grenzzahl gebildet. Das Modul wird so festgelegt, dass sich ein ASCII-Wert ergibt, dem ein darstellbares alfanumerisches Zeichen entspricht. Beim Beispiel von Fig. 2 wird aus der Quersumme Q die Restklasse modulo 128 gebildet, was die Grenzzahl 121 ergibt, die in der ASCII-Tabelle dem Buchstaben "y" entspricht. Dieser Buchstabe bildet nun das Prüfzeichen P und wird an das Ende der Datenzeile 2 gesetzt. Selbstverständlich können anstatt des beschriebenen Algorithmus auch andere aus der digitalen Datenverarbeitung bekannte redundanzbildende Algorithmen verwendet werden.

Bei dem dargestellten Ausführungsbeispiel wird ein Prüfzeichen P pro Datenzeile erzeugt, welches aus der Kombination aller Datenzeichen dieser Zeile unter Anwendung des beschriebenen Algorithmus besteht. Durch dieses Verfahren wird ein einzelner Fehler sicher detektiert, weil das fehlerhaft dargestellte Zeichen einen falschen Beitrag zur Quersumme liefert, die dann nicht mehr dem eingeblendeten Prüfzeichen P entspricht. Allerdings kann dieser einzelne Fehler nicht lokalisiert werden, was aber eher unproblematisch ist. Denn man kann davon ausgehen, dass auch dann, wenn ein Fehler lokalisiert ist, man also beispielsweise sagen kann, dass zwar die Geschwindigkeit stimmt, aber nicht das Datum, eine darartige Angabe die Anforderungen an ein gerichtlich zulässiges Beweismittel nicht erfüllen würde.

Also wird es sinnvoll sein, eine Fotografie mit einer fehlerhaften Einblendung bei der Auswertung in jedem Fall zu verwerfen; und dann ist es auch nicht nötig, einen Fehler lokalisieren zu können.

Mehrere Fehler würden nur dann nicht erkannt, wenn sie sich genau so kompensieren, dass die richtige Quersumme entsteht, was aber eher unwahrscheinlich ist. Wenn auch Mehrfachfehler sicher erkannt werden sollen, müssen den Datenzeichen mehrere Prüfzeichen beigefügt und die Algorithmen derart angewendet werden, dass jedes Zeichen auf unterschiedliche Weise zur Bildung dieser mehreren Prüfzeichen beiträgt. Derartige Verfahren zur Datensicherung sind in der digitalen Datenverarbeitung bekannt.

Selbstverständlich ist das beschriebene Verfahren nicht auf die Sicherung von Daten beschränkt, die in ein fotografisch hergestelltes Bild eingeblendet werden. Die Art der Herstellung des Bildes und dessen Träger sind sekundär. Das Verfahren kann daher insbesondere auch bei Videobildern angewandt werden.

## Patentansprüche

1. Verfahren zur Sicherung von in ein Bild in Form alfanumerischer Zeichen eingeblendeter Daten, dadurch gekennzeichnet, dass den genannten Daten (D, h, v) Redundanz in Form von zusätzlichen, durch Kombination zumindest einzelner Zeichen der Daten mit einem definierten Algorithmus gebildete Prüfinformation beigegeben und in das Bild (DF) eingeblendet wird.

2. Verfahren nach Anspruch 1, dadurch gekennzeichnet, dass jedem alfanumerischen Zeichen der Daten (D, h, v) ein Zahlenwert eindeutig zugeordnet wird und die einzelnen Zahlenwerte zu einem repräsentativen Gesamtwert verarbeitet werden, und dass aus diesem Gesamtwert die Prüfinformation abgeleitet wird.

3. Verfahren nach Anspruch 2, dadurch gekennzeichnet, dass die Prüfinformation in Form eines alfanumerischen Prüfzeichens (P) in das Bild (DF) eingeblendet wird.

4. Verfahren nach Anspruch 3, dadurch gekennzeichnet, dass zur Ueberprüfung der eingeblendeten Daten (D, h, v) aus diesem mit dem gleichen Algorithmus ein Prüfzeichen gebildet und auf Uebereinstimmung mit dem eingeblendeten Prüfzeichen (P) überprüft wird.

5. Verfahren nach Anspruch 3 oder 4, dadurch gekennzeichnet, dass die den alfanumerischen Zeichen zugeordneten Zahlenwerte zu einer Summe (Q) addiert, und dass aus dieser Summe durch Restklassenzerlegung mit einem geeigneten Modul eine Grenzzahl gebildet wird, welche die Basis für das Prüfzeichen (P) bildet.

6. Verfahren nach Anspruch 5, dadurch gekennzeichnet, dass das Modul für die Restklassenzerlegung so gewählt wird, dass die Grenzzahl einen Zahlenwert ergibt, dem ein darstellbares alfanumerisches Zeichen entspricht, und dass dieses Zeichen das Prüfzeichen (P) darstellt.

7. Verfahren nach Anspruch 6, bei welchem die Daten die von einer Anlage zur automatischen Geschwindigkeitsüberwachung registrierte Geschwindigkeit von Verkehrsteilnehmern enthalten, welche zusammen mit weiteren Daten wie Ort und/oder Datum und/oder Uhrzeit in ein Datenfeld eines die jeweilige Verkehrssituation zeigenden Bildes eingeblendet sind, dadurch gekennzeichnet, dass in das Datenfeld (DF) zusätzlich das genannte Prüfzeichen (P) eingeblendet ist.

8. Vorrichtung zur Durchführung des Verfahrens nach Anspruch 1, gekennzeichnet durch eine Tabelle, in welcher jedem möglichen Zeichen ein Zahlenwert zugeordnet ist, durch Mittel zur Verarbeitung der den zumindest einzelnen Zeichen zugeordneten Zahlenwerte zu einer für die jeweilige Einblendung repräsentativen Prüfinformation, und durch Mittel zur alfanumerischen Anzeige und Einblendung dieser Prüfinformation in Form eines Prüfzeichens (P).

9. Vorrichtung nach Anspruch 8, gekennzeichnet durch einen Speicher zur Aufnahme der Tabelle und durch einen mit diesem Speicher verbundenen Mikrorechner, durch welchen eine Verarbeitung der einzelnen Zahlenwerte zu einem Gesamtwert und eine Ableitung einer in der genannten Tabelle enthaltenen Grenzzahl erfolgt, welche in Form eines das Prüfzeichen (P) bildenden alfanumerischen Zeichens darstellbar ist.
